# EUROPEAN PATENT APPLICATION

(11) **EP 0 877 421 A2**
(43) Date of publication of application: **11.11.1998**
(21) Application number: 98108387.6
(22) Date of filing: 08.05.1998
(51) Int. Cl.: H01L 21/768, H01L 21/3205

(54) **Sputter deposition and annealing of copper alloy metallization M**

(30) Priority: 08.05.1997 US 853191; 18.06.1997 US 878143
(71) Applicant: Applied Materials, Inc., Santa Clara, California 95052 (US)
(72) Inventor: Chiang, Tony, Mountain View, California 94043 (US); Ding, Peijun, San Jose, California 95129 (US); Chin, Barry, Saratoga, California 95070 (US); Hashim, Imran, Fremont, California 94538 (US); Sun, Bingxi, Sunnyvale, California 94086 (US)
(74) Representative: Kahler, Kurt, Dipl.-Ing.

(57) **Abstract**

A copper metallization structure and its method of formation in which a layer (100) of a copper alloy, such as Cu-Mg or Cu-Al is deposited over a silicon oxide based dielectric layer (64) and a substantially pure copper layer (102) is deposited over the copper alloy layer (100). The copper alloy layer (100) serves as a seed or wetting layer for subsequent filling of via holes (66) and trenches with substantially pure copper and also provides barriers at the interfaces with the underlying dielectric and the overlying pure copper. The copper alloy may be deposited cold in a sputter process, but, during the deposition of the pure copper layer (102) or afterwards in a separate annealing step, the temperature is raised sufficiently high to cause the alloying element of the copper alloy to migrate to the dielectric layer (64). Alternatively, the copper alloy may be deposited with the wafer held at an elevated temperature. The alloying element that has migrated to the oxygen-rich surfaces oxidizes to form thin stable layers (70), for example of magnesium or aluminum oxide, that act as barriers there against diffusion of copper into and through the dielectric layer (64). The inner barrier also promotes adhesion of the alloy layer to the dielectric layer (64), thereby forming a superior wetting and seed layer for subsequent copper full-fill techniques. Filling of the alloy-lined feature can be accomplished using PVD, CVD, or electro/ electroless plating.

## Description

### FIELD OF THE INVENTION

The invention relates generally to metal deposition in the fabrication of semiconductor integrated circuits. In particular, the invention relates to copper metallization, particularly accomplished by physical vapor deposition.

### BACKGROUND ART

A critical part of any advanced semiconductor integrated circuit involves the one or more metallization levels used to contact and interconnect the active semiconductor areas, themselves usually residing in a fairly well defined crystalline silicon substrate. Although it is possible to interconnect a few transistors or other semiconductor devices, such as memory capacitors, within or immediately on top of the semiconductor level, the increasingly complex topology of multiply connected devices soon necessitates another level of interconnect. Typically, an active silicon layer with transistors and capacitors formed therein is overlaid with a dielectric layer, for example, silicon dioxide. Contact holes are etched through the dielectric layer to particular contacting areas of the silicon devices. A metal is filled into the contact holes and is also deposited on top of the dielectric layer to form horizontal interconnects between the silicon contacts and other electrical points. Such a process is referred to as metallization.

A single level of metallization may suffice for simple integrated circuits of small capacity. However, dense memory chips and especially complex logic devices require additional levels of metallization since a single level does not provide the required level of interconnection between active areas. Additional metallization levels are achieved by depositing over the previous metallized horizontal interconnects another level of dielectric and repeating the process of etching holes, now called vias, through the dielectric, filling the vias and overlaying the added dielectric layer with a metal, and defining the metal above the added dielectric as an additional wiring layer. Very advanced logic device, for example, fifth-generation microprocessors, may have five or more levels of metallization.

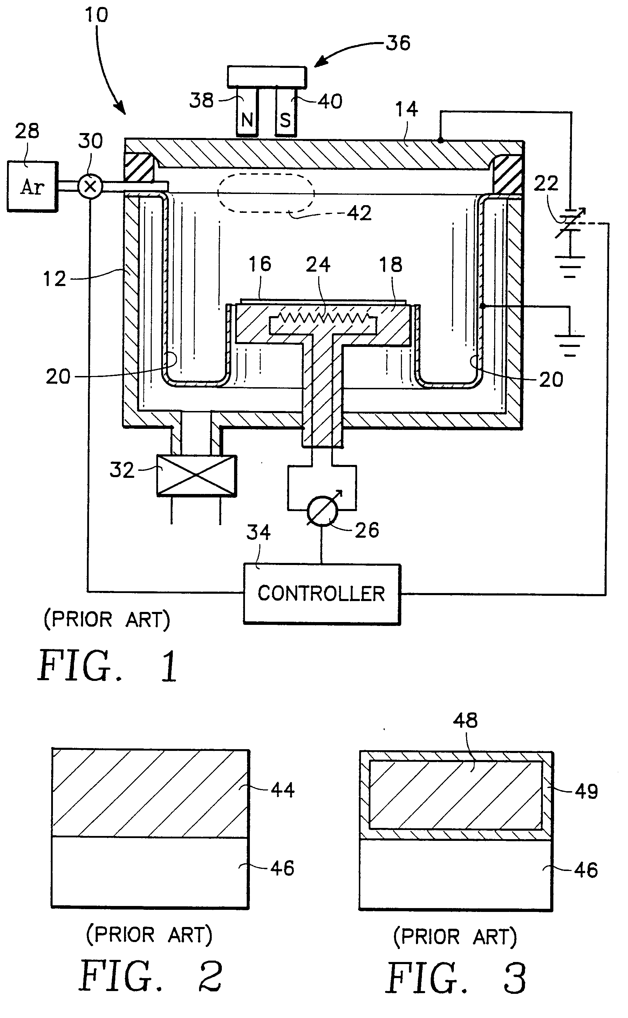

Conventionally, the metallized layers have been composed of aluminum and aluminum-based alloys additionally comprising at most a few percent of alloying elements such as copper and silicon. The metallization deposition has typically been accomplished by physical vapor deposition (PVD), also known as sputtering. A conventional PVD reactor 10 is illustrated schematically in cross section in FIG. 1, and the illustration is based upon the Endura PVD Reactor available from Applied Materials, Inc. of Santa Clara, California. The reactor 10 includes a vacuum chamber 12 sealed to a PVD target 14 of the material to be sputter deposited on a wafer 16 held on a heater pedestal 18. A shield 20 held within the chamber protects the chamber wall 12 from the sputtered material and provides the anode grounding plane. A selectable DC power supply 22 biases the target negatively to about -600VDC with respect to the shield 20. Conventionally, the pedestal 18 and hence the wafer is left electrically floating. The heater pedestal 18 includes a resistive heater 24 powered by an adjustable electrical power supply 26.

A gas source 28 of sputtering working gas, typically chemically inactive argon, supplies the working gas to the chamber through a mass flow controller 30. A vacuum pump system 32 maintains the chamber at a low pressure. Although the base pressure can be in the range of about 10⁻⁷ or even lower, the pressure of the working gas is kept between 1 and 100mTorr. A computer-based controller 34 controls the operation of the parts of the reactor including the DC power supply 22, the heater power supply 26, and the mass flow controller 30.

When the argon is admitted into the chamber, the DC voltage ignites the argon into a plasma, and the positively charged argon ions are attracted to the negatively charged target 14. The ions strike the target 14 at a substantial energy and cause target atoms or atom clusters to be sputtered from the target 14. Some of the target particles strike the wafer 16 and are thereby deposited on it, thereby forming a film of the target material.

To provide efficient sputtering, a magnetron 36 is positioned in back of the target. It has opposed magnets 38, 40 creating a magnetic field within the chamber in the neighborhood of the magnets 38, 40. The magnetic field traps electrons, and for charge neutrality, the ion density also increases to form a high-density plasma region 42 within the chamber adjacent to the magnetron 36. However, it is understood that a plasma of decreasing density extends towards the wafer 16. The high-density plasma increases the sputtering rate, and the magnetron 36 is scanned over the back of the target 14 to provide a more uniform sputtering process.

With the continuing miniaturization of integrated circuits, the demands upon the metallization have increased. Many now believe that aluminum metallization should be replaced by copper metallization. Murarka et al. provide a comprehensive review article on copper metallization in "Copper metallization for ULSI and beyond," *Critical Reviews in Solid State and Materials Science*, vol. 10, no. 2, 1995, pp. 87-124. Copper offers a number of advantages. Its bulk resistivity is considerably less than that of aluminum, 1.67µΩ-cm vs. 2.7µΩ-cm for pure material, and any reduction in resistivity offers significant advantages as the widths and thicknesses of the metallization interconnects continue to decrease. Furthermore, a continuing problem with aluminum metallization is the tendency of aluminum atoms in an aluminum metal to migrate along the metallization interconnects under high current densities, especially migrating away from hot spots, in a process called electromigration. Any excessive amount of such migration will break an aluminum interconnect and render inoperable the integrated circuit. Copper-based alloys exhibit significantly reduced levels of electromigration over aluminum and its alloys.

Thus, in many ways, the bulk behavior of copper is superior to that of aluminum, but copper metallization is an unproven technology and is acknowledged to offer difficulties not experienced with the conventional aluminum metallization. However, it may afford ways to circumvent problems inherent in aluminum metallization. Two major problems have been identified which impedes the adoption of copper in commercial circuits.

It has proven difficult to etch copper by a dry etch process, that is, by plasma etching. The etch problem seems to have been circumvented by the development of the damascene process in which a trench, perhaps with a via hole at its bottom, is etched into the silicon dioxide dielectric layer. The trench follows the intended path of the horizontal interconnect. A blanket deposition of copper fills the trench and additionally forms a layer over the dielectric. The wafer is then subjected to chemical mechanical polishing (CMP) to remove all copper exposed above the top of the trench and thus to leave a copper interconnect in the trench.

Another set of problems addressed by this invention involves the interfaces between the copper and other parts of the integrated circuit. A principal advantage of aluminum is its good interfacial characteristics. Aluminum forms a stable oxide layer, Al₂O₃, and it forms strong chemical bonds with silicon. Copper oxidizes, but the oxide is not stable and continues to grow over time upon exposure to a moist oxygen ambient. Copper and copper oxides do not adhere well to silicon dioxide. Finally, copper diffuses very quickly through silicon dioxide and can produce a short through or across the dielectric layer unless means are adopted to prevent the copper from entering the silicon dioxide. In the prior art, a separate barrier layer was deposited over the silicon dioxide before the copper was deposited to prevent the copper from diffusing into and through the oxide.

Murarka et al. in the aforecited review article recommend alloying copper with magnesium or aluminum to improve the interfacial qualities. Later work done by the Murarka group at Rensselaer Polytechnic Institute and their collaborators have developed a useful technique for forming dependable copper interconnects and provide a model for its operation. As Lanford et al. describe in "Low-temperature passivation of copper by doping with Al or Mg," *Thin Solid Films*, vol. 262, 1995, pp. 234-241, sputtering is used, as illustrated in the schematic cross section of FIG. 2, to deposit a film 44 of copper alloy on a substrate 46. Examples of the alloying element include aluminum and magnesium. The copper alloy film 44 can be deposited as alternating layers of copper and the alloying element, or the two constituents can be co-sputtered, for example, by use of a copper alloy sputtering target. After completion of the sputtering at near to room temperature, the wafer is annealed, for example, at 400°C in argon for 30 minutes. As illustrated in the cross section of FIG. 3 the annealing causes a large fraction of the magnesium to diffuse to the outside of a remaining copper film 48 and to react with any oxygen present at the interfaces to form a film 49 of magnesium oxide. The MgO film 49 encapsulates the Mg-alloyed Cu body 44. The upper free surface of the copper film 48 is passivated by the MgO film 49 Magnesium oxide is a stable oxide and stops growing at a thickness in the range of 5 to 7nm. The thin oxide is not believed to cause a high contact resistance, but in any case the oxide can be removed by a sputter etch prior to the deposition of a subsequent metallization. Lanford et al., *ibid*., suggest that the free surface is oxidized to MgO by oxygen impurities in the argon.

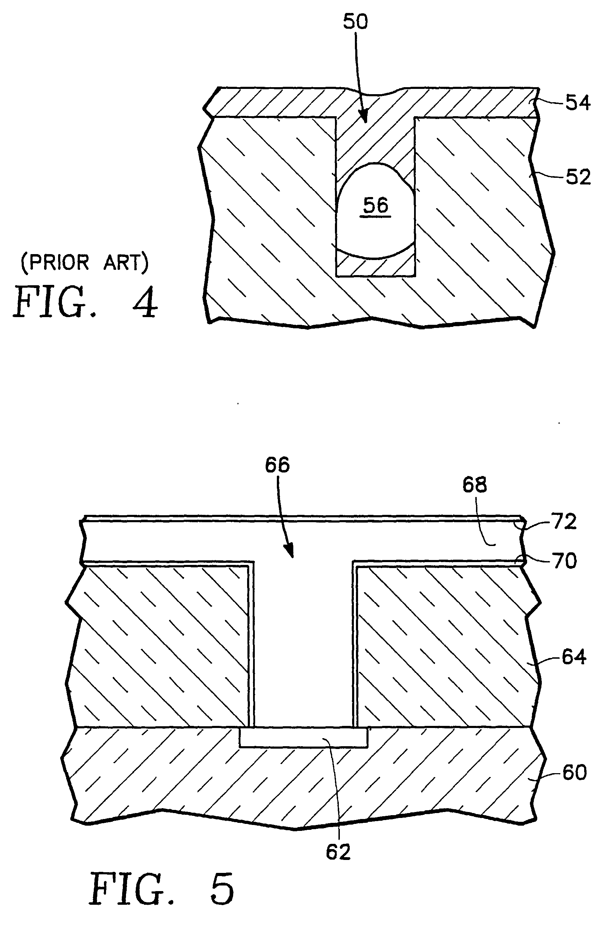

Metallization in advanced integrated circuits faces a demanding requirement in filling high-aspect ratio holes. Increasing device density requires that the feature sizes be further reduced. However, dielectric breakdown has prevented the thickness of interlevel dielectric levels from being similarly reduced. As a result, the aspect ratio of vias and contacts has been increasing. The aspect ratio is the ratio of the depth of the hole through the dielectric forming the via or contact and the minimum lateral size of that hole. An aspect ratio of 5:1 is considered developmental technology, but even higher values will be required. Assuming that high aspect-ratio holes cap be etched, the problem remains of filling them with metal for the interlevel connection. The geometry of high aspect-ratio holes is unfavorable for sputtering since conventional sputtering is fairly isotropic so that little sputtered material strikes the bottom of the hole compared to the lip of the hole, and the sputtering is likely to bridge the top of the hole and prevent any further deposition. The hole filling problem is illustrated in cross section in FIG. 4. A narrow and deep hole 40 is etched into a silicon oxide substrate 42, which contains unillustrated structure to be electrically contacted. A copper layer 44 is then filled into the hole 40. If the filling is performed by a standard PVD process including an initial cold deposition to form a surface layer followed by a hot final deposition to complete the filling, a void 46 is likely to form in the hole because the copper dewets from the oxide sides of the hole 40. Once the copper bridges over the void 46 midway through the deposition, it is virtually impossible to remove the void and complete the hole filling.

At least two techniques are used to overcome the unfavorable geometry of hole filling, directional sputtering and reflow. In directional sputtering, one or more of various techniques are used to produce a flux of sputtered particles incident upon the wafer which are heavily concentrated in the normal direction. Reflow relies on the fact that metals flow at moderately low temperatures so that the metal, although initially deposited in a undesirable distribution, is made to flow into the hole and to fill it. The reflow may be produced in a post-deposition anneal or may occur on an ongoing basis during a hot deposition.

Directional sputtering may be achieved by many methods, including long-throw, collimation, and electrostatic attraction of ionized sputtered ions in a high-density plasma. Directional sputtering, although not required by the invention, is advantageously used in conjunction with it, as will be discussed later.

Reflow of metallizations, especially copper, presents several difficulties. Unlike aluminum, copper has a relatively high melting point. Heating the substrate to the melting temperature of the metallization would incur too high a thermal budget and may be inconsistent with prior processing steps. Aluminum and copper do flow at somewhat lower temperatures than their melting points, but the interface between either of these metals and the silicon dioxide forming the usual interlevel dielectric is not favorable for reflow. Neither aluminum nor copper wets well with silicon dioxide at certain high temperatures. As a result, these metals do not flow in a smooth layer down a wail of silicon dioxide. Indeed, if aluminum or metal is present as a thin layer on a surface of silicon dioxide, the metal tends to ball up in isolated locations.

Xu et al. have addressed the reflow problem with aluminum metallization in U.S. Patent Application, Serial No. 08/628,835, filed April 5, 1996. They recommend using a carrier layer of TiN and possibly Ti deposited by a high-density plasma to perform a number of functions including increasing the adhesion of aluminum deposited in a narrow aperture extending through silicon dioxide. The carrier layer acts as a glue layer that adheres well to silicon dioxide and also acts as a wetting layer for the later deposited aluminum. As a result, the aluminum flows down the carrier layer at a relatively low temperature and thus easily fills the hole.

### SUMMARY OF THE INVENTION

One aspect of the invention includes a metallization process and the resultant product in which a copper alloy comprising a few percent of an alloying element such as magnesium, aluminum, boron, and tantalum are sputtered onto a substrate containing an oxide surface portion, for example, silicon dioxide forming the walls of a via hole. Elevated temperature causes the alloying element to diffuse toward the oxide on the sidewalls and form a thin, stable alloying metal oxide that acts as a barrier against diffusion of the copper into and through the silicon oxide. If sufficient oxygen is present during the sputtering step, a metal oxide will form on the top surface of the copper alloy. Preferably, the copper alloy is sputtered onto the substrate while it is held at an elevated temperature sufficient to promote the alloying element diffusion during the sputtering.

Another aspect of the invention includes a structure and fabrication method for copper metallization including a copper alloy film deposited, preferably by cold sputtering, on a dielectric layer of silicon oxide. A purer copper film is then deposited on the copper alloy layer, and after the start of copper deposition the temperature is raised to promote the diffusion of the alloying element within the copper alloy layer.

The invention is applicable, among other uses, to copper filling of narrow apertures, such as vias and trenches. The invention is also applicable to planarization of copper.

### BRIEF DESCRIPTION OF THE DRAWINGS

FIG. 1 is a schematic cross-sectional view of a conventional PVD reactor.

FIGS. 2 and 3 are cross sectional views illustrating the conventional encapsulation of a copper alloy body.

FIG. 4 is a schematic cross-sectional view of a void formed in filling a hole in a dielectric.

FIG. 5 is a cross sectional view of a via filled with copper according to an embodiment of the invention.

FIGS. 6 and 7 are graphs of the atomic profiles of Mg and O across the copper alloy films of the invention.

FIG. 8 is a graph of the resistivity as a function of annealing time for a CuMg alloy that was deposited cold and then annealed at the indicated temperatures.

FIG. 9 is a graph of the resistivity as a function of hold time for a CuMg alloy that was deposited at the indicated temperatures and then held at that temperature.

FIG. 10 is a cross section view of a via filled with copper according to a second embodiment of the invention.

FIG. 11 is a cross-sectional view of a via filled with copper according to one embodiment of the invention.

FIG. 12 is an enlarged cross-sectional view of a portion indicated by circle 12-12 of FIG. 11 after the formation of the barrier.

### DETAILED DESCRIPTION OF THE PREFERRED EMBODIMENTS

The present invention includes a production-efficient process of forming a copper alloy film in which the sputter deposition of the alloy is closely associated with its anneal.

A first embodiment of the invention, illustrated in cross section in FIG. 5, is an upper interlevel via. A lower level includes a lower interlevel dielectric layer 60, typically formed of silicon dioxide or silicate glass, that is, silicon oxide. A copper-based interconnect or pad 62 is formed in the upper surface of the lower dielectric layer 60. An upper level dielectric layer 64 of silicon dioxide or silicate glass is deposited over the lower dielectric layer 60, and a via hole 66 is etched through the upper dielectric layer 64 in the area of the copper pad 62. Physical vapor deposition (PVD) is then used to deposit a copper-alloy film 68 into the via hole 66 and on top of the upper dielectric layer 64. Both the copper and its alloying element, for example, magnesium, are sputtered at the same time so that a particle flux of uniform composition falls on the substrate. This co-sputtering is most easily accomplished by using a sputter target having a composition close to that of the desired copper alloy although some difference in composition may occur between the sputter target and the sputter deposited film because of differential sputtering yields between the two elements.

The copper alloy film 68 is either deposited at a relatively elevated temperature or is annealed after deposition so that the alloying element migrates to the surfaces to form a metal oxide diffusion layer 70 adjacent to the upper dielectric layer 54 and a metal oxide passivation layer 72 at the top, free surface. The oxygen for the metal oxides is supplied either by the silicon dioxide in the silica layer 64 or by residual oxygen in the argon or vacuum environment used for the sputtering or separate annealing step. Too high an oxygen partial pressure will oxidize the copper to form copper oxide since insufficient alloying element is diffusing to the surface to tie up the available oxygen. As will be shown later, the metal in the metal oxide diffusion layer 70 includes both the alloying element and some silicon while the metal in the metal oxide passivation layer 72 is primarily the alloying element. In the case of the alloying element being magnesium, both the metal oxide layers 70, 72 are composed at least in part of MgO, a stable oxide that forms to a thickness of about 7nm under normal conditions and then stops growing. Such a thin oxide passivation layer 72 does not present significant electrical resistance in a direction perpendicular to the plane of the oxide layer. Note that no oxide layer forms adjacent to the first-level metal 62 because no significant amount of oxygen is available at that interface. No separate layer is illustrated because it is assumed that the alloying element freely diffuses into the first-level metal 62 at the same rate as it diffuses through the copper alloy film 66.

In one method of practicing the invention, the copper alloy is sputtered with the wafer held at an elevated temperature sufficient to anneal the copper alloy as it is being sputter deposited. That is, it is a hot sputter deposition. Preferred temperatures are described later. As illustrated in FIG. 1, the Endura PVD reactor includes the heater 24 in its wafer pedestal 18 capable of providing the temperatures required for the invention. In the case of hot sputter deposition, although a uniform copper alloy is being deposited, the alloying element diffuses outwardly and forms the inner oxide layer 70 next to the silicon dioxide dielectric layer 64 and the outer oxide layer 72. Because no oxygen is readily available at the top of the copper pad 622, no inner oxide layer is formed over the copper pad 22. An advantage of the real-time annealing is that the initially deposited copper alloy immediately reacts with the silicon oxide to form a combined oxide of silicon and the alloying element. This interface provides much better adhesion for later deposited copper or copper alloy than is available from the combination of copper and silicon oxide.

In a second general method of performing the invention, the copper alloy film 68 is PVD deposited at lower temperatures, for example, room temperature, at which no significant annealing or diffusion of the alloying element occurs. After the copper alloy deposition, the wafer is annealed. The annealing can be performed *in situ* in the PVD chamber in which the copper alloy film has been deposited or in a separate annealing furnace, and the annealing ambient can be a vacuum or a purge gas such as argon. The post-deposition annealing can be performed within the same PVD chamber in which the copper alloy film was deposited if the heater pedestal is capable of providing the somewhat higher temperatures required for a post-anneal. Alternatively, the wafer can be moved to a separate annealing chamber for an *ex situ* anneal. However, the transfer to the annealing chamber needs to be performed within a controlled environment that is essentially oxygen free, for example, 10⁻⁹Torr. The Endura cluster tool from Applied Materials can be used for a vacuum transfer.

Murarka demonstrates the differences between annealing and high-temperature oxidation in "Use of advantageous impurity effects in metallization," *Materials Research Society Symposium Proceedings*, vol. 405, pp. 485-496, 1996. When an otherwise untreated CuAl alloy film was heated to 300°C in air, a copper oxide layer forms and grows to about 70nm over 20 hours. That is, the CuAl film oxidized. On the other hand, when the CuAl film was annealed in an argon ambient for 30 minutes at 400°C, subsequent annealing as described immediately above did not produce a measurable copper oxide layer. That is, the initial anneal in a reduced oxygen environment prevents subsequent oxidation.

A number of experiments were performed using the copper alloy metallurgy but in a planar configuration. The first two experiments concentrated on the metal oxide barrier layer 72, and no effect of the metal oxide passivation layer 70 is seen.

### Experiment 1

In a first series of experiments, a planar copper metallization of various forms was formed over a 100nm-thick layer of silicon dioxide over a conducting silicon substrate, and a metal contact was applied to the copper metallization. An additional contact was applied to the conductive substrate. The samples were then electrically stressed by applying a potential of 2MV/cm across the oxide layer with the sample held at 275°C. The leakage current was monitored as a function of time. At some point, sufficient copper diffused across the oxide to cause it to be a reasonably good conductor. A threshold current was considered to represent a failure. A sufficient number of samples were measured to calculate a mean time to failure (MTTF).

For the inventive samples, the copper alloy was Cu with 2 atomic % of Mg sputter deposited to a thickness of about 200nm. The results for three types of preparations are shown in TABLE 1, together with one comparative sample.

**TABLE 1**

| Barrier | Deposition/Anneal | MTTF (hours) | Min MTTF (hours) | Max MTTF (hours) |
|---|---|---|---|---|
| CuMg | RT deposition; anneal @ 350C, 10 min. | 2.2 | 0.12 | 8.19 |
| CuMg | Deposition @ 250C; 5 min. hold | 3.1 | 0.10 | 7.80 |
| CuMg | Deposition @ 150C; 5 min. hold | 3.2 | 1.3 | 5.6 |
| Cu only | | <0.1 | | |

In the first inventive sample, the CuMg alloy was sputter deposited at close to room temperature and was then annealed for 10 minutes at 350°C in 1mTorr of argon. The MTTF was reasonably large, but the range of MTTF values extended to undesirably short times. In the second inventive sample, the CuMg was sputter deposited with the wafer held at 250°C, and the wafer temperature was held for 5 minutes after completion of sputtering. The MTTF increased, but the range was still too wide. In the third inventive sample, the CuMg was instead sputter deposited at 150°C with the same post-sputter hold. The MTTF was good, and the range was substantially narrowed. However, the statistics are too meager to reach definite conclusions, and the three process should be considered at this time to produce comparable results. These values compare to the last entry for a comparative sample in which a copper film had no substantial amount of alloying, and no barrier was formed between the copper and the oxide. The MTTF was too short to measure.

### Experiment 2

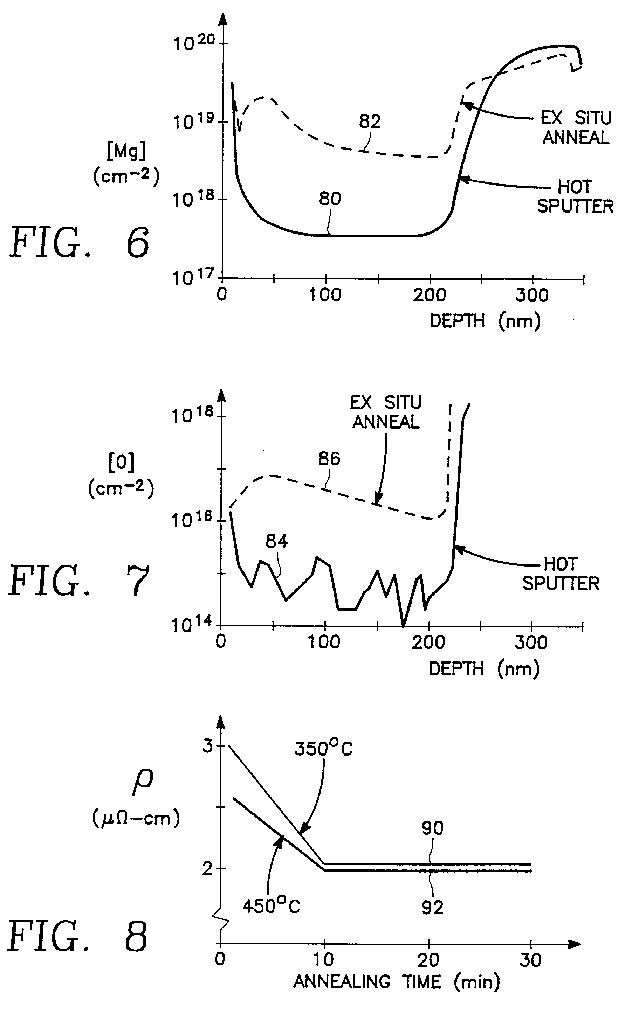

The atomic profiles were measured on inventive planar samples prepared similarly to those described above. The profiling was performed with secondary ion mass spectroscopy. The atomic concentrations of magnesium are shown in FIG. 6. Curve 80 gives the profile for a sample sputter deposited at 250°C with Cu and 2 atomic % Mg with no separate, elevated-temperature annealing step. Curve 82 gives the profile for a sample sputter deposited at less than 50°C which was then annealed at 350°C. Both samples show a definite diffusion of the Mg to the free surface and toward the silicon oxide underlayment. The Mg then diffuses into the silicon oxide, but the concentration falls off after about 100nm. However, the hot deposited copper alloy shows greater depletion of the Mg in the principal portion of the Cu, which would provide reduced electrical resistance. The atomic concentrations of oxygen are shown in FIG. 7. Curve 84 gives the profile for a hot sputtered sample deposited at 350°C with no annealing while curve 86 gives the profile for the previously described cold sputtered sample with *ex situ* annealing. A 7nm surface oxide layer is too thin to be accurately measured by this technique. The hot deposited sample has substantially reduced oxygen concentration in the bulk of the copper, clearly advantageous for reduced electrical resistance.

Thus, the hot sputter has the advantages of eliminating a separate annealing step and of decreasing the amounts of the alloying element and of the oxygen impurities in the remaining copper film.

### Experiment 3

Some of the same samples used in the profiles of FIGS. 6 and 7 were measured for their resistivity as a function of deposition and annealing temperatures, and these results provide another basis for optimizing treatment temperatures.

Two sets of samples were PVD deposited with the Cu alloy having 2 atomic % Mg with the wafers being held nominally at room temperature. One set of samples were then annealed *ex situ* at 350°C in a vacuum environment, that is, an *ex situ* anneal. The resistivity of the CuMg film was measured as a function of the length of this anneal. The 350°C results are shown by curve 90 in FIG. 8. Another set of samples were annealed at 450°C, and these results are shown by curve 92. For interconnects, the resistivity should be minimized. These results suggest a minimum post-annealing temperature of 350°C for about 10 minutes in order to minimize the thermal budget.

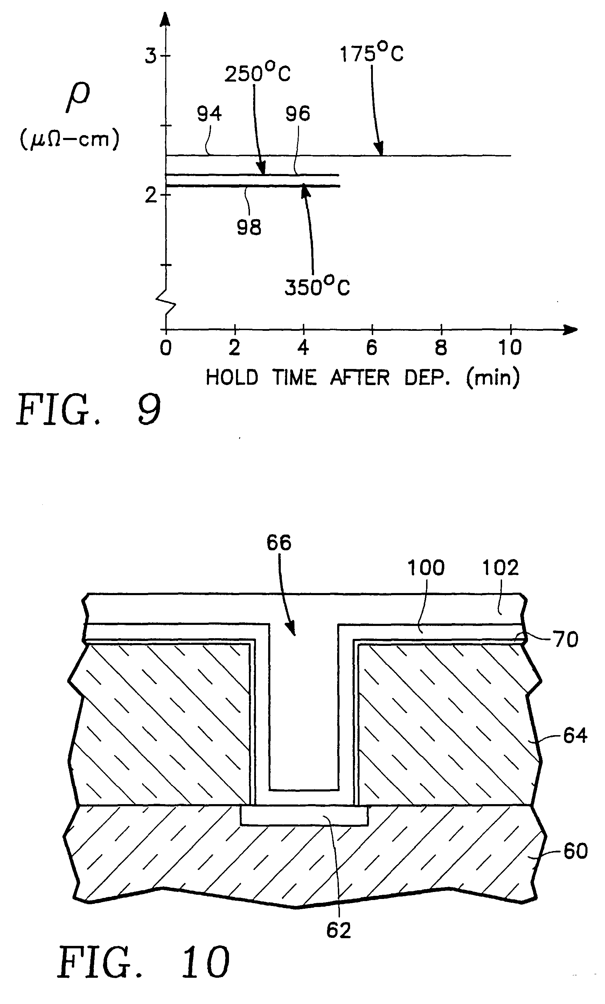

In a related experiment, three more sets of samples were PVD deposited with CuMg alloy at an elevated deposition temperature. After cessation of sputter deposition, the samples were held at the deposition temperature for a varied time. The results for 175°C sputtering are shown by line 94 in FIG. 9; for 250°C sputtering, by line 96; and for 350°C sputtering, by line 98. These results show that hold time has little effect; that is, the *in situ* annealing during deposition is sufficient to achieve low resistivity. These results also show that the sputtering temperature should be a minimum of 250°C to achieve minimum resistivity at minimum thermal budget. It is anticipated that an optimum temperature range for *in situ* annealing is 200 to 300°C. However, the results of TABLE 1 indicate that the diffusion barrier characteristic is improved at an even lower deposition temperature of 150°C. Although resistivity data is not available at this temperature, the trend of FIG. 9 indicates an acceptable resistivity at this temperature. Hence, resistivity can be traded against the diffusion resistance.

Comparing the results of FIGS. 8 and 9, both the *ex situ* and *in situ* anneal are capable of producing nearly the same low value of resistivity. However, the thermal budget is minimized with the real-time *in situ* anneal of FIG. 9.

The structure illustrated in FIG. 5 assumed that a uniform copper alloy film 68 completely fills the via hole 66. However, many of the benefits of the invention can be obtained with a very thin copper alloy film of less than 50nm thickness. Even a thickness of 5nm seems sufficient. As illustrated in the cross-sectional view of FIG. 10, a conformal film 100 of the copper alloy is deposited into the via hole 656 and on top of the second dielectric oxide layer 64. The conformality of the copper alloy film 100 in a narrow and deep via requires special techniques such as HDP, long throw, or collimation. Fu et al. have disclosed an alternate technique in U.S. Patent Application, Serial No. 08/854,008, filed May 8, 1997. In their technique, which is particularly applicable to copper sputtering, an anode grid is inserted between the target and the substrate to allow sustained self-sputtering and to provide a more directional sputter deposition.

Either a hot sputtering process or a post anneal will cause the alloying element in the conformal copper alloy film 60 to diffuse to the dielectric oxide layer 64 and form the previously described metal oxide barrier layer 760. A separate deposition process deposits a copper layer 102, which fills the via hole 656 and overlies the upper dielectric layer 64. No alloying element is required in the copper layer 102 since the barrier layer 70 is formed from the alloying element in the copper alloy film 100. The hole filling may be performed by many processes including PVD, CVD, or electro or electroless plating. Murarka describes electroless plating of copper in his previously cited article in *Critical Reviews*. The copper layer 102 more readily fills the via hole coated with the copper alloy film 100 so the second copper deposition does not require special hole filling techniques. As mentioned before, the annealed copper alloy layer, particularly when hot deposited, provides a good adhesion layer to the silicon oxide.

### Experiment 4

A series of samples were tested for corrosion resistance. The samples of the previously described copper magesium alloy, after fabrication as described below, were annealed in an oven at 150°C with air ambient for about 30 minutes. After annealing,the samples were visually inspected for surface corrosion. The results are shown in TABLE 2.

**TABLE 2**

| Process | Anneal/Dep Temperature (°C) | Hold/Anneal Time (minutes) | Color |
|---|---|---|---|
| ex situ anneal | 500 | 30 | partially brown |
| hot sputter | 200 | 5 | blue |
| hot sputter | 300 | 5 | blue |
| hot sputter | 400 | 0 | partially brown |
| hot sputter | 400 | 10 | OK |

The first sample was sputtered at room temperature and then annealed at 500°C in a separat*e ex situ* anneal. Its surface was partially brown indicating some copper oxidation. The second and third samples were hot sputtered at 200 and 300°C respectively and held at those temperatures for 5 minutes. Both had a blue appearance, indicating partial copper oxidation. The fourth sample was hot sputtered at 400°C with no post-deposition hold. The partially brown color indicated copper oxidation. The last sample was hot sputtered at 400°C and held at that temperature for 10 minutes after sputtering. No color change was apparent.

These results indicate that to minimize surface corrosion, hot sputtering is preferred, and the hot sputtering should be performed at above 300°C and preferably at 400°C and above with a significant post-deposition hold. Thus, considerations of surface corrosion indicate a higher hot-sputtering temperature and a longer hold than do considerations of barrier properties. Also, an *ex situ* anneal does not seem to produce satisfactorily low surface corrosion. Of course, surface oxide can be removed by a sputter pre-etch prior to a subsequent deposition.

The invention is not limited to the described copper alloys. Generally, the atomic alloying percentages will range up to 10 atomic %. However, it is now generally believed that the Mg alloying should be kept below 6 atomic % and the Al alloying should be kept below 0.3 atomic % although thin layers will require a higher alloying concentration. A minimum alloying percentage is 0.05 atomic %. Other metal alloying elements, such as tantalum and boron, can be used which form stable oxides and readily diffuse through copper.

The first aspect of the invention thus provides a self-generating barrier between a copper metallization and an oxide layer, and no separate barrier deposition is required. For the hot sputter deposition, no additional annealing is required. The copper metallization and associated barrier may be used for filling via structures or as a thin barrier layer.

The above discloses the advantages of a self-annealed copper metallization including an alloying element such as magnesium or aluminum. When deposited under the proper conditions, the alloying element readily diffuses to both the interface at the exposed top surface to form a self-passivating metal oxide layer with the alloying element and to form a barrier of an oxide of the alloying metal and silicon at the underlying silica interface.

The above disclosure is primarily directed to the formation and advantages of the barrier between the copper and silica. We have discovered that similar processes with possibly some variations can be advantageously used for hole filling.

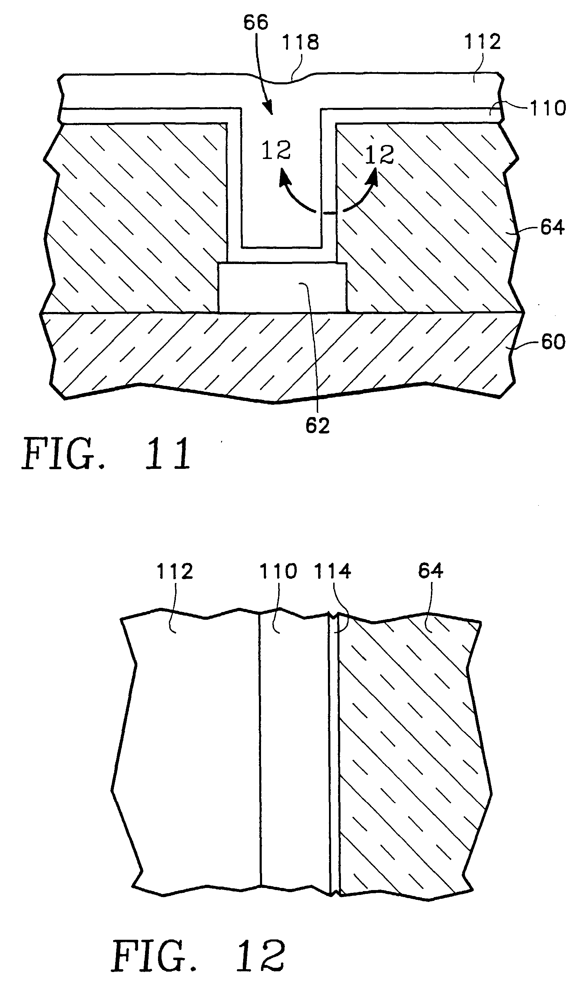

According to another embodiment of the invention, as illustrated in the cross-sectional view of FIG. 11, a substrate includes a first dielectric layer 60 having a metal line 62 on its surface. The discussion will primarily be directed to interlevel vias, that is, conductive holes from one level of metallization to another, rather than to contacts to underlying silicon areas. A second dielectric layer 64 is deposited over the metal line 62 and the first dielectric layer 60. The second dielectric layers 64 in this embodiment is composed of a silicon oxide, for example, silicon dioxide deposited by a plasma-enhanced CVD process, although other forms of silica and silicate glasses can also be used to much the same effect. The metal line 62 is preferably formed of copper although the copper technology of the invention can be combined with lower aluminum metallization, for example, of Al/Ti/TiN. A via hole 66 is photolithographically etched through the second dielectric layer 64 down to the underlying metal line 62.

A seed layer 110 of a copper alloy is then sputter deposited into the via hole 66 and atop the second dielectric layer 64 under conditions favoring good bottom and sidewall coverage of the narrow via hole 66. Fu et al. disclose in above cited U.S. Patent Application a reactor for sustained self-sputtering of copper, which can be advantageously used for the required nearly conformal sputter deposition of copper and its alloys.

The seed layer 110 needs to be deposited only to a very small thickness of about 5 to 10nm. It may be thicker, up to about 200nm, but additional thickness detracts from production efficiency in the hole filling process to be described later. Thus, a thickness of no more than 50 or 100nm is preferred in a production environment. If the seed layer 110 is being used to fill a narrow hole, the stated thickness is that on the side and bottom of the hole. The thickness of a sidewall deposition may be only a fraction of the thickness of deposition on a planar top surface with the ratio depending upon the feature size, its aspect ratio, and the sputtering conditions. The seed layer 110 can be sputter deposited under hot conditions so that the layer 110 self-anneals during deposition. A hot sputter is performed preferably with the substrate held in the range of 200 to 400°C although higher temperatures are possible. However, the complexity of hot sputtering is not required for many of the effects of the invention. Instead, the seed layer 110 can be sputter deposited under cold conditions below 200°C or even below 100°C, temperatures not favoring the diffusion of the alloying element to the interfaces. It is possible under cold sputter deposition that a copper oxide layer forms at the exposed surface of the seed layer 110, but the preferred filling process removes the copper oxide.

We have observed that the copper alloy seed layer 110 forms with a very smooth surface. In particular, a 200nm thick Cu-Mg layer deposited on SiO₂ and thereafter annealed at 450°C for 30 minutes produced a very smooth surface. A 20nm layer of pure copper similarly deposited over a 20nm tantalum barrier over SiO₂ produced gross agglomeration of the copper, indicating severe dewetting at temperatures as low as 200°C. These results indicated that a smooth copper alloy seed layer 110 provides good wetting to after deposited copper and thus promotes copper full-fill of deep vias and trenches.

After the thin seed layer 110 has been deposited, the via hole 66 is filled by a second deposition step with relatively pure copper. By relatively pure copper is meant copper that is at least 99 atomic % pure, and the 1% impurity or doping level does not apply to the alloying elements discussed here. The full-fill deposition step producing the copper layer 62 may be performed by PVD, by chemical vapor deposition (CVD), or by electroplating or electroless plating. These deposition methods are described by Murarka et al. in the previously cited article in *Critical Reviews*. Preferably, the alloy seed layer 110 is deposited in a cold sputter, and the pure copper deposition is performed before the seed layer is annealed. As a result, it is likely that the copper alloy seed layer 110 spontaneously oxidizes to form a surface layer of copper oxide although the oxygen can be annealed out because of the Cu-O bond is not very strong. For a PVD copper full-fill, it should be performed at a relatively high temperature above 300°C, preferably 400 to 550°C. The second PVD deposition may be a standard PVD process, collimated PVD, high-density plasma PVD, or yet other variations. For CVD deposition, a plasma preclean may be used. Electroplating will naturally remove the copper oxide. The smooth surface of the copper alloy seed layer 110 promotes reflow into via hole at relatively low temperatures without dewetting due to the good adhesion of Cu-Mg to the oxide. A smooth Cu alloy surface promotes adhesion for the later deposited copper. For CVD copper, reflow temperatures of no more than 200°C are need; for electroplated copper, no more than 100°C.

After the via filling, the structure is annealed to cause the alloying element to diffuse within the copper alloy seed layer 110. The alloying element diffuses towards the dielectric layer 64 and forms a very thin barrier layer 114, as illustrated in the enlarged cross-sectional view in FIG. 12, at the interface between the seed layer 110 and the dielectric layer 64 that prevents copper from diffusing into and through the silica dielectric layer 64. The barrier layer 114 comprises an oxide of the alloying element along with some of the silicon. The alloying element will also diffuse into the copper fill 112, but the thickness of the planar overlayer of copper needs to be minimized if the thin seed layer 60 is to provide enough alloying element to form a surface passivating layer. Typically, however, the free-surface passivation is not important because the entire surface will be polished flat in a subsequent step of chemical mechanical polishing. The annealing is preferably performed within the temperature range of 300 to 400°C although temperatures up to 600°C can be used if they do not thermally degrade other structures on the wafer.

The annealing can be performed in a separate annealing furnace or by rapid thermal processing involving radiant lamps. It also can be performed by *in situ* PVD annealing, that is, either a PVD deposition performed at an elevated substrate temperature or an anneal performed in the PVD chamber after cessation of the PVD deposition. The annealing ambient may be either high vacuum, a forming gas to minimize oxidation, or a reduced oxygen partial pressure to form a surface layer of the oxide of the alloying element, *e*.*g*., MgO or Al₂O₃, but not copper oxide.

The single copper alloy seed layer 110 thus provides both a barrier layer at the silica interface and as and adhesion/wetting layer at the copper interface. In the prior art, separate barrier and wetting layers had been required for filling deep holes in silica with copper.

Although the description above referred to a hole via for a generally square or circular via hole, the invention may be applied to other geometries. The aperture may be a trench extending a substantial distance along the surface of the dielectric. The trench need not extend through the dielectric, and the pure copper may be applied as a relatively thin conformal layer over the alloy layer in the trench.

Another application of the alloy seed layer of the invention is for copper planarization. As shown in FIG. 11, a small dimple 118 forms at the surface of the copper layer 112 overlying the via hole 66. In view of the fact the via hole 66 may be much deeper than the thickness of the planar portion of the copper layer 112, the geometry of hole filling would indicate a much deeper dimple 118, which could severely impact later formed layers. However, the same effects produced by the seed layer of the invention which promote full filling of deep holes also promote the planarization of the upper surface of the copper layer 112 due to lateral reflow of the copper as it is being deposited or is afterwards annealed, thereby reducing the size of the dimple 118.

Although magnesium is the most preferred alloying element for copper and aluminum is also known to provide beneficial results, yet other alloying elements have been used with copper, for example, boron, tantalum, tellurium, and titanium. To provide the benefits described above, such an alloying element should form stable oxides and readily diffuse through copper. Generally, the atomic alloying percentages range up to 10 atomic %. However, it is now generally believed that the Mg alloying should be kept below 6 atomic % and the Al alloying should be kept below 0.3 atomic %. A minimum alloying percentage is 0.05 atomic %.

The invention thus provides a copper metallization structure that exhibits many beneficial characteristics without undue complexity in the structure or its fabrication. The copper alloy not only provides a barrier at the dielectric interface and passivation at the free interface but also promotes the deposition of a later deposited copper layer. The effect is particularly effective in filling holes of high aspect ratios.

## Claims

1. A method of forming a copper metallization, comprising the steps of:
a first step of sputter depositing onto a dielectric part of a substrate comprising an oxide a copper alloy layer comprising copper and less than 10 atomic percent of an alloying element; and
a second step of depositing onto said copper alloy layer a copper layer.

2. The method of Claim 1, wherein said copper layer consists of substantially pure copper.

3. The method of Claim 1, wherein said first step is performed while maintaining said substrate at a temperature equal to or above 200°C.

4. The method of Claim 3, wherein said temperature is no more than 400°C.

5. The method of Claim 1, wherein said second step comprises plating copper.

6. The method of Claim 1, wherein said second step comprises chemical vapor deposition of copper.

7. The method of Claim 3, wherein said second step comprises physical vapor deposition of copper.

8. The method of Claim 7, wherein said first step is performed while holding said substrate at a first temperature that is substantially lower than a second temperature in said second step sufficiently high to cause said alloying element to diffuse in said copper alloy layer.

9. The method of Claim 8, wherein said first temperature is less than 200°C.

10. The method of Claim 9, wherein said first temperature is less than 100°C.

11. The method of Claim 1, further comprising annealing said structure after said second step to cause said alloying element to diffuse in said copper alloy layer.

12. The method of Claim 1, wherein said first step is performed while holding said substrate at a temperature below 200°C.

13. The method of Claim 12, wherein said alloying element comprises magnesium.

14. The method of Claim 13, wherein said magnesium is present in an amount of between 0.05 and 6 atomic %.

15. The method of Claim 1, wherein said alloying element comprises aluminum.

16. The method of Claim 15, wherein said aluminum is present in an amount between 0.05 and 0.3 atomic %.

17. The method of Claim 1, wherein said alloying element is selected from the group consisting of boron, tantalum, tellurium and titanium.

18. The method of Claim 1, wherein said oxide comprises silicon oxide.

19. A metallization structure, comprising:
a dielectric layer comprising oxygen;
a copper alloy layer formed over said dielectric layer comprising copper and less than 10 atomic percent of an alloying element; and
a substantially pure copper layer deposited over said copper alloy layer.

20. The metallization structure of Claim 19, further comprising an interfacial oxide layer between said copper alloy layer and said dielectric layer which comprises silicon, said alloying element, and oxygen.

21. The metallization structure of Claim 19, wherein said alloying element comprises magnesium.

22. The metallization structure of Claim 21, wherein said magnesium is present in an amount of between 0.05 and 6 atomic %.

23. The metallization structure of Claim 19, wherein said alloying element comprises aluminum.

24. The metallization structure of Claim 23, wherein said aluminum is present in an amount between 0.05 and 0.3 atomic %.

25. The metallization structure of Claim 19, wherein said alloying element is selected from the group consisting of boron, tantalum, tellurium and titanium.

26. The metallization structure of Claim 19, wherein said dielectric layer includes an aperture extending into said dielectric layer and wherein said copper alloy layer is coated onto sides of said aperture.
